# EUROPEAN PATENT SPECIFICATION

(11) **EP 0 729 294 B1**
(45) Date of publication and mention of the grant of the patent: **02.09.1998**
(21) Application number: 95500098.9
(22) Date of filing: 05.07.1995
(51) Int. Cl.: H05K 9/00

(54) **Arrangement for preventing eletromagnetic interference**
Vorrichtung zur Verhinderung elektromagnetischer Störung
Dispositif protégant des interférences électromagnétiques

(30) Priority: 24.02.1995 EP 95500019
(43) Date of publication of application: 28.08.1996
(73) Proprietor: Hewlett-Packard Company, Palo Alto, California 94304 (US)
(72) Inventor: German,Robert F., Boulder, CO 80304 (US); Soler,Xavier, E-08190 Sant Cugat del Valles(Barcelona) (ES); Frost,Andrew, E-08190 Sant Cugat del Valles(Barcelona) (ES); Lewis,Richard, E-08190 Sant Cugat del Valles(Barcelona) (ES)
(74) Representative: Duran Moya, Luis-Alfonso

(56) References cited:
- EP-A- 0 486 398
- EP-A- 0 658 079
- CH-A- 674 288
- US-A- 4 739 453

## Description

This invention refers to a new device for the prevention of electromagnetic interference.

As is already known, many pieces of electronic equipment generate electromagnetic interference (or noise) which can cause interference with certain parts of the same equipment that is generating the noise or with other electronic units located near the said equipment. On the other hand, the attenuation of electromagnetic energy emitted by electronic apparatus is already regulated by law in some countries like the U.S. and others and is about to be in the near future throughout the E.U. In order to reduce the effects of the said interference or level of emissions, very many types of metallic screens or shields and protective devices have been devised which are usually interposed between the point or points from which the aforesaid electromagnetic radiation may be proceeding and the circuits which may be affected by interference caused by the said radiation.

Among the technical measures used to avoid the said interference, one which has been widely practiced is the use of a metallic or electrically conductive enveloping enclosure, i.e. an electromagnetic protection which accommodates the whole system in its interior and prevents the transmission of electromagnetic radiation or prevents electromagnetic radiation from other sources from being able to penetrate into the protected space.

In the event of conductors being required which penetrate the enclosure or of there being mechanical interaction with the outside in connection with motors, keyboards, etc., the solution of just enveloping the unit or protecting it by means of an electromagnetic protecting enclosure is many times not adequate, because of the degradation of the electromagnetic shielding caused by firstly simple holes and, more critically, conducting cables and elements that act as radiators. The solutions generally followed are: 1) for simple holes: to reduce as far as possible their dimensions, 2) for the cables: filtering measures are needed.

In some cases, use is made of special connectors provided with protection and filtering systems, but these represent a high cost and constitute an inflexible mechanical solution. They work well where they have become the standard, for example as I/O connectors for computers and peripherals, but are extremely expensive and inflexible for internal device connections. In other cases use is also made of ferrites fitted to the conductors outside the enclosure. This arrangement is also expensive, difficult to assemble and adds complexity.

From US-A-4 739 453 there is further known a shielding apparatus for a printed circuit board.

In view of the technical problems described and the present state of the art, the object of the present invention is to achieve a satisfactory solution to the problem of attenuation of electromagnetic interference using a system which has the benefits of using low cost components, a simplified assembly and flexible arrangement options that can be applied in a systematic and reliable way to all products having the aforementioned needs. It is particularly applicable to machines such as plotters which are relatively large and therefore generally need long conductors. However, it is equally applicable to small products in which cost could be saved by using smaller shielding enclosures.

In order to achieve its objectives, the present invention proposes an arrangement as defined in claim 1 such that the required filtering components for the input/output conductors are arranged on the actual printed circuit board inside an electromagnetic protecting enclosure which extends to 360° in the zone in which the conductors pass through the walls of the electromagnetic protecting enclosure in conjunction with small apertures or windows where required for the passage of the conductors and with the arrangement of a part of the same printed circuit board on the outside of the aperture or groove through which the conductors pass and in such a way that the connections are arranged outside the protective enclosure.

According to the present invention, the printed circuit board is therefore divided into two distinct zones, the first of which carries the relevant electronic parts and is duly protected by means of the relevant electromagnetic protecting enclosure, while the other zone is outside that same enveloping protective enclosure and has ordinary connections located on it.

To achieve good contact between the circuit board and the enclosure, the present invention envisages the arrangement of conducting zones, normally made of tinned copper, which are arranged on one or preferably both faces of the printed circuit, respectively, and have a conductive joint which has to show good electrical conduction to the protective enclosure. According to one embodiment, which is favourable for mechanical tolerance reasons, a flexible joint may be a good solution although a direct rigid connection may be used.

Filtering of the undesired high frequency noise can be achieved by use of standard or conventional components mounted as normal onto the circuit board, and which connect to the aforementioned conducting zones to achieve the return path required by such filters.

By these means, electromagnetic shielding, as far as required, for both conducted and radiated emissions, can be provided for the "noisy" side of the circuit board allowing the same board to simply pass through a mechanically simple slot or slots, while maintaining all the benefits of standard and cheap components and easy assembly/disassembly.

A preferred practical embodiment envisages the mounting of the printed circuit unit on the lower half of the protective envelope, the upper part of the said protective envelope then being attached in the manner of a sandwich made up of the lower metal part of the enclosure, the printed circuit unit and the upper part of the protective metal enclosure. The input/output connectors remain in the printed circuit board unit, outside the envelope for the electronic devices to be protected and, in this way, the connection of the input/output conducting cables is carried out very easily and can use more inexpensive connector components. Therefore, the invention describes an arrangement of components that provides an electromagnetic filter, for a Faraday cage type of shield, that allows conductors for signals or for power to pass through it without compromising its effectiveness and with standard cheap easily assembled parts. Therefore according to one embodiment, the present invention provides that:
a) The enveloping enclosure providing protection against electromagnetic interference has an aperture or apertures to permit the passage of a part or parts of the printed circuit board which extends to the outside of the enclosure, the said aperture or apertures carrying electrically conductive joints for establishing contact to one or both of the upper and lower faces of the printed circuit board;
b) The printed circuit board is made up of two distinct zones:
   - a first zone having sources of unwanted electromagnetic emissions, and
   - a second zone which is electrically connected with the first area via conductors, allowing suitable connection to other devices,
c) the shielding means enclose at least portions of the first zone of the printed circuit board for shielding direct electromagnetic emissions originating from said first area, and
d) filtering means incorporated into the printed circuit board and coupled to the shielding means are provided for removing or attenuating unwanted signal components from the signals being transmitted from the first zone to the second area via the conductors.
e) Means are arranged to provide a good high frequency electrical connection between the filtering system and the protective enclosure.

The present invention also envisages the arrangement of a number of transverse conducting elements providing communication between the upper and lower conductive zones associated to the PCB, which connect to the enclosure, the said conducting elements determining, in conjunction with the corresponding upper and lower conducting zones, a number of transverse windows of reduced dimensions which are intended for the passage of the input/output conductors from the inner precinct protected by the enveloping enclosure to the outer precinct.

The present invention also provides for a second variant form of embodiment in which the connections are disposed in an intermediate zone on the panel or printed circuit of the electronic apparatus. In this version, which may be more advantageous for a number of specific cases of embodiment of the electronic apparatus, it will be possible to establish the separation of one or a series of intermediate zones on the panel in which the connections are made and which will be separated or insulated electromagnetically from the rest of the panel, by means of an arrangement of joints which make contact with the enveloping enclosure, in a similar manner to the preferred version, by way of laminar contact elements or any means making the required electrical contact disposed on the upper and lower parts of the panel, and transverse interconnecting elements. This second variant form of embodiment may, like the preferred version, utilize the upper and lower faces of the printed circuit board, or only one of the sides of the said board, which will correspond to the one in which the connections are made. In both above versions the protective enclosure can also be incorporated in the board itself, if needed.

According to another embodiment of the invention, the same principles and means for attenuation of electromagnetic interference which have been disclosed in the aforegoing may be used for the protection of the components in the printed circuit board from disturbances entering from the outside, through the conductors, that is, the reverse of the foregoing teaching in which the filtering means were arranged to avoid the electromagnetic disturbances generated by the elements on the printed circuit board within the enclosure from being transmitted via the conductors passing through the enclosure to the external connectors.

The invention is also applicable to the case in which it is desired to separate the elements of a printed circuit board in two sections, one of them containing more delicate components and being electromagnetically protected from the other section of the circuit board or "dirty" section by the same arrangements as for separating the two previously explained zones.

Some preferred embodiments of the present invention will be described below by way of non-limitative examples and with reference to the accompanying drawings.

Figure 1 shows, in diagrammatic form, a filter for high frequency signals.

Figures 2 and 3 show, respectively, a longitudinal section and a transverse section, both diagrammatic, through an embodiment of a device according to the present Patent of Invention.

Figure 4 is a transverse section through a second embodiment of the present invention with 360° protection and cable filtering, and with the connectors disposed in an intermediate zone on the printed circuit.

Figure 5 shows a third embodiment, similar to that in Figure 4, but without any contact between the lower part of the enclosure and the underside of the circuit board.

Figure 6 illustrates a cross section of an embodiment in which parts of the circuit board are separated within the same enclosure.

Figure 7 shows the arrangement of the filtering means for protecting the circuit board from external electromagnetic disturbances.

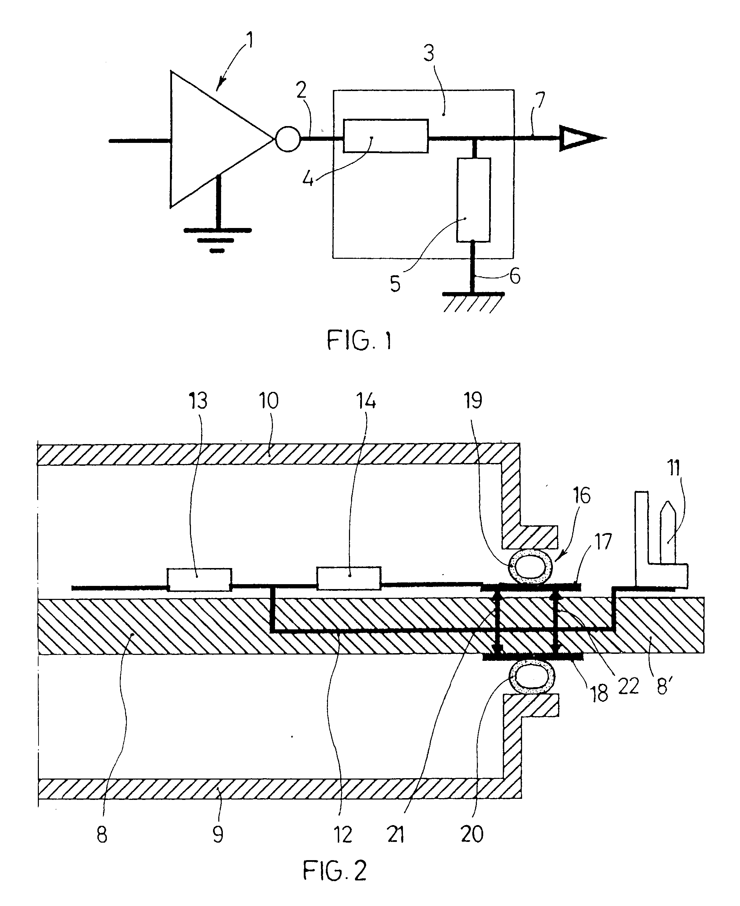

In a conventional system, as illustrated diagrammatically in Figure 1, an electronic device -1- has been illustrated with an input/output conductor -2- which has a filter -3- for electromagnetic noise attenuation comprising, for that purpose, conventional components, which are diagrammatically illustrated by the numerals -4- and -5-, and a connection -6- which provides a good high-frequency low impedance return path to the enclosure. The output -7- will receive a connection which is not illustrated.

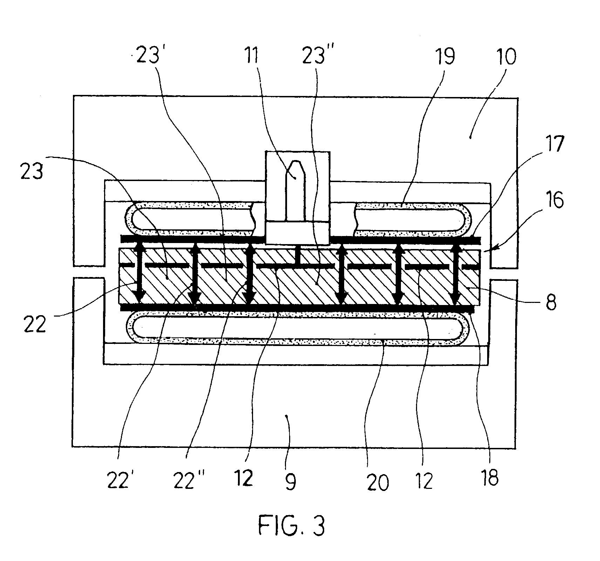

The device envisaged in the present Patent of Invention is intended to achieve great simplicity and economy in the protection of printed circuits against high frequency electromagnetic interference. To that end, as has been illustrated diagrammatically in Figures 2 and 3, according to a first embodiment, part of the printed circuit board -8- is fully or partially contained inside two electromagnetic protecting enclosure components -9- and -10- which have electrical conduction characteristics and which sandwich, the circuit board and which contain, inside them, all the electronic components integrated in the printed circuit, in such a way that the said printed circuit continues into a part -8'- which is arranged on the outside of the enveloping enclosure -9-10-, the said zone being intended to receive the connectors which are indicated, in a diagrammatic manner, by the numeral -11-. According to the present invention, the filtering of the conductors, for example the conductor -12-, is carried out inside the enveloping electromagnetic protecting enclosure -9-10-, electronic filtering elements -13- and -14- having been illustrated diagrammatically.

Even though, in this description, reference is made to connectors -11-, which are then connected to other devices with cables, the invention also encompasses the possibility of any other form of connection to these same devices, such as for example direct assembly on the same printed circuit board -8'-.

According to the present invention, between the components -9- and -10- which make up the outer protective enclosure, a longitudinal opening or groove -16- is formed through which the printed circuit board passes and which has coupled to it at the top and bottom individual conducting zones -17- and -18- which are produced, for example, by means of copper or other suitable metal. According to this embodiment, conductive joints such as -19- and -20- are provided which make contact, respectively, with the upper and lower conducting zones -17- and -18- and the edges of the enveloping enclosure.

Between the upper and lower metal zones -17- and -18- a number of interconnecting conductors may be arranged, if needed, which are illustrated by the numerals -21- and -22- in Figure 2 and which are normally aligned along the groove, as will be noted in Figure 3 in which can be seen the conducting elements -22-, -22'-, -22''-, ..., which are variable in number and determine intermediate windows of small dimensions such as -23-, -23'-, -23''-, ..., through which the conductors originating from the internal zone of the printed circuit and from the filtering systems will pass. The said conductors have been illustrated diagrammatically by the numeral -12- in Figure 2, and are finally connected into the ordinary connections -11- arranged on the outside of the enveloping enclosure -9-10-.

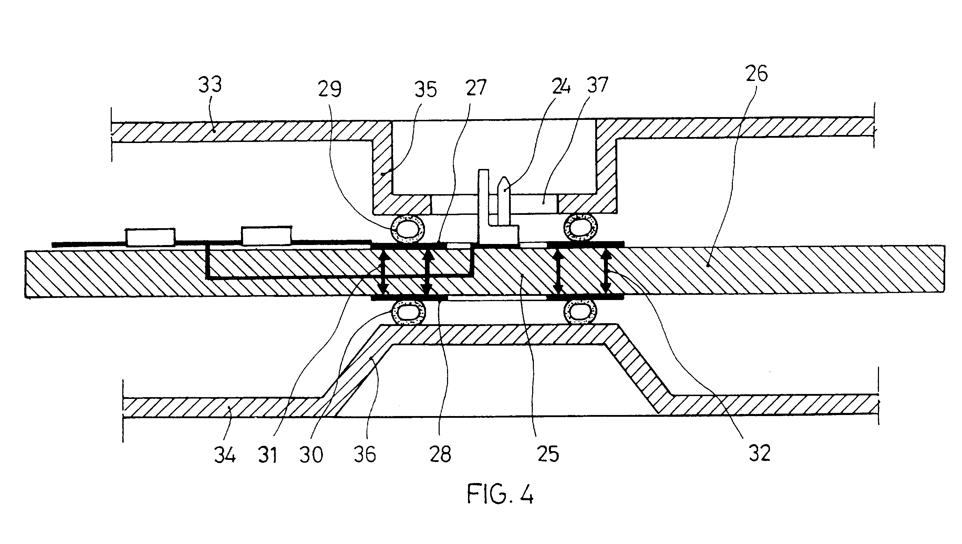

In a second embodiment of the present invention, which is illustrated in Figure 4, the connectors -24- are disposed in an intermediate zone -25- on the printed circuit board (PCB) -26-, which permits better adaptation to certain types of apparatus. In this case, according to the present invention, the electromagnetic insulation of the intermediate zone -25- is effected by means of the upper and lower conducting areas -27- and -28-, which will assume the form of closed loops on each face of the printed circuit board -25-, which receive individual conductive joints -29- and -30- which are similar to those in the preferred embodiment of the present invention. Between the conducting areas -27- and -28- there will be set up interconnecting conductors, if needed, such as -31- and -32- in a similar manner to the main version.

In this case, the upper wall -33- and lower wall -34- making up the enveloping enclosure of the electronic apparatus are shown with individual inset portions or concave zones -35- and -36- in order to reach the level corresponding to the joints -29- and -30-, the bottom of the concavity -35- having an aperture -37- intended for the passage of the connectors.

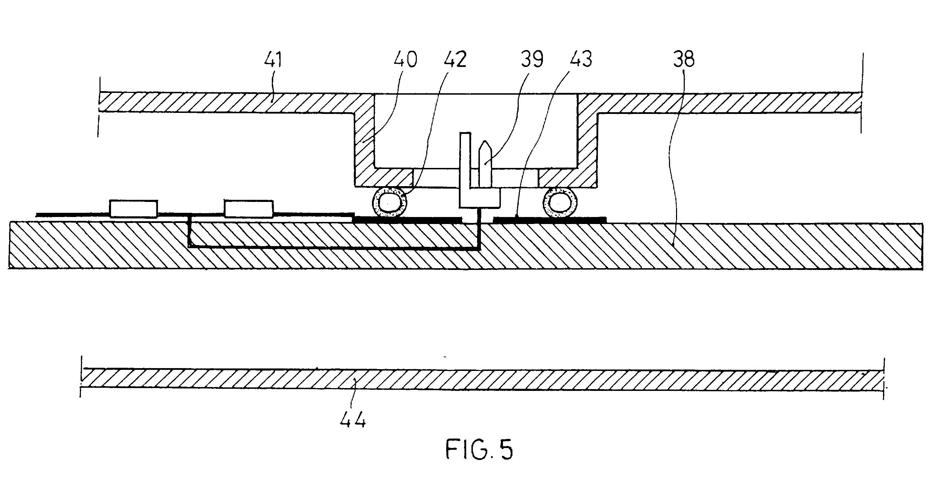

This constructional variant also may be achieved as shown in Figure 5, in which can be seen elements equivalent to those in Figure 4 in the upper part of the envelope of the PCB, and which shows the PCB, which is indicated in this case by the numeral -38-, and the connector -39- located in the bottom of a concavity -40- in the upper wall -41- of the envelope of the panel, there being a single conductive joint -42- and a single contact part in the upper face of the PCB -38-, which is indicated by the numeral -43-. In this case, there is no need for contact in the lower part with the wall -44-, because the closing of the electromagnetic shield previously formed by the ring of vertical conductors plus the "lid" of the bottom wall is here performed directly by a metal screen on the top face of the PCB. Another intermediate solution between these two is this metal screen on the bottom of the circuit board connected by a ring of vertical conductors.

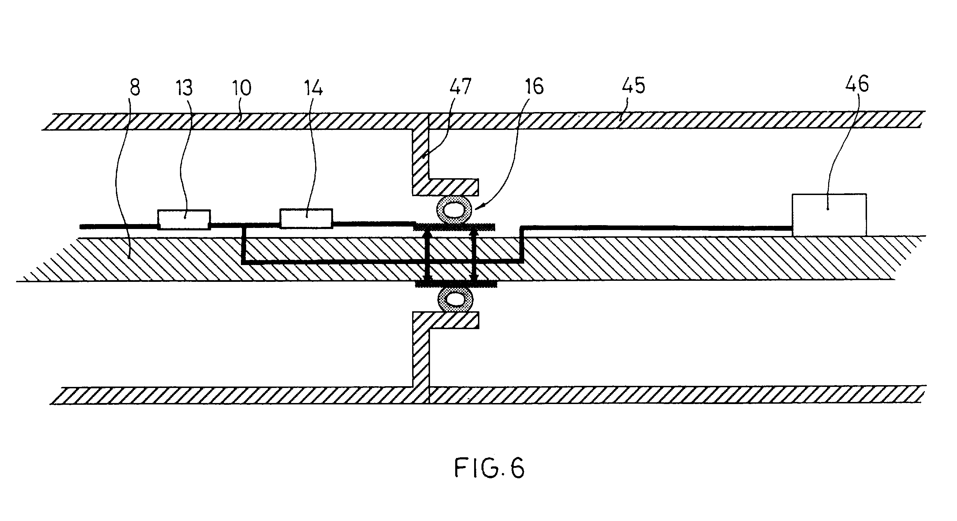

The invention is also applicable to the case in which it is desired to separate the elements of a printed circuit board in two sections, one of them containing more delicate components and being electromagnetically protected from the other section of the circuit board or "noisy" section by the same arrangements as for separating the two previously explained zones -8- and -8'-. This embodiment, which has been shown in figure 6, features a second enveloping enclosure -45- which eventually may be a part of the enveloping enclosure -10- for section -8-. The second enveloping enclosure protects the components -46- of the printed circuit board which is desired to protect from the "noisy" section of components contained in zone -8-. The filtering means represented by the same references -13- and -14- as above explained will protect components -46- from emissions coming from said "noisy" section. In the case that the enveloping enclosure is the same for both parts of the circuit board, there will be an internal wall -47- in the common enclosure through which the circuit board will pass with the same closing and contact arrangements as explained for figures 1 and successive.

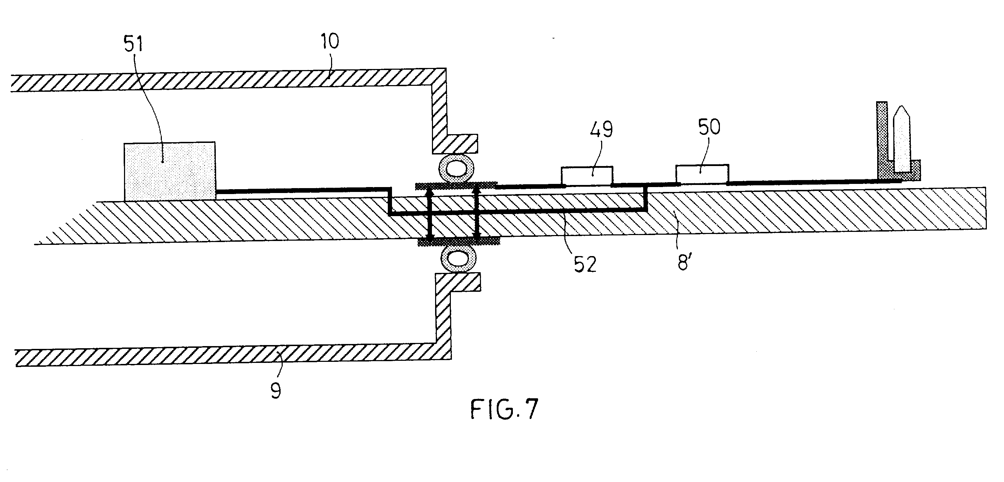

According to another embodiment of the invention, the same principles and means for attenuation of electromagnetic interference which have been disclosed in the aforegoing may be used for the protection of the components in the printed circuit board from disturbances entering from the outside, through the conductors, that is, the reverse of the aforegoing teaching in which the filtering means were arranged to avoid the electromagnetic disturbances generated by the elements on the printed circuit board within the enclosure from being transmitted via the conductors passing through the enclosure to the external connectors. In this case, which has been shown in figure 7, the filtering means represented by numeral references -49- and -50- are arranged on the external part -8'- of the circuit board protecting the electronic devices -51- inside of the enclosure -9-, -10- against electromagnetic disturbances which might be channelled by the conductors -52- from the outside to the internal elements contained within the enclosure -9-, -10-.

By means of these arrangements, a number of advantages of both a functional and economical type are achieved. The following, in particular, can be stated:

The enveloping electromagnetic protecting enclosure is effectively continuous in the apertures for the passage of the conductors to the outside.

The connections made in the upper and lower output parts of the printed circuit have the benefit of a number of easily designed implementations.

The connections are arranged outside the protective enclosure and allow great flexibility of design, facilitate the changing of connectors used and are also remarkably simple and easy to manufacture and assemble to.

This arrangement also makes it possible to achieve the separation of two clearly differentiated zones of the same PCB, one of them being an electromagnetically noisy or dirty zone and situated inside the protective enclosure and the other, which is basically electromagnetically quiet or clean, being the one which corresponds to that part of the printed circuit which is located outside the actual electromagnetic protecting enclosure.

There are greater possibilities for the design of the printed circuit, incorporating the appropriate filters and using more types of commercially available connectors or parts.

An additional sealing function can be obtained by the use of suitable commercially available gaskets which provide a sealing function in addition to electrical contact.

There is the establishing of an effective system of "small windows" through which the conductors pass with 360° protection and with the possibility of producing the said apertures with reduced dimensions, thereby achieving a high degree of protection against the passage of electromagnetic radiation.

As will be realized, the foregoing description of a preferred example of embodiment of the present invention is not limitative as regards the scope of the present invention, so persons skilled in the art will be able to introduce a large number of variations which will still be included within the scope of the following claims.

## Claims

1. Arrangement for preventing electromagnetic interference in electronic apparatus having a printed circuit board, the arrangement wherein :
(a) the printed circuit board comprises two types of zones:
- a first type of zone (8) having sources of high frequency energy, and which is located within an electrically conductive enveloping enclosure or shield (9, 10) designed to inhibit or attenuate direct electromagnetic radiation, and
- a second type of zone (8') which is electrically connected to the first zone via conductors (12), which is not contained within the same enclosure or part of the enclosure containing the first type of zone (8), allowing connection to other devices,
(b) filtering means (13, 14), are incorporated on the circuit board, which are designed to remove or attenuate unwanted high-frequency energy from the conductors (12) interconnecting the two zones (8, 8'), and
(c) a high frequency electrical connection (19, 20) between the filtering means (13, 14) and the enclosure (9, 10) is arranged at the boundary or boundaries of the two different types of zones of the printed circuit board (8, 8').

2. Arrangement according to claim 1, in which the second type zone (8') is located outside of the enveloping enclosure (9, 10).

3. Arrangement according to claim 1, in which the connection between the filtering means (13, 14) and the enclosure (9, 10) is achieved via conductive zones (17, 18) on the upper and/or lower faces of the printed circuit board at the boundary of the two types of zones (8, 8').

4. Arrangement according to claim 3, whereby the conductive zones (17, 18) are electrically interconnected to one another by means of transverse conducting elements (21, 22, 22' ...).

5. Arrangement according to claims 1 to 4 whereby the mechanical and electrical contact between the enclosure (9, 10) and the conductive zones (17, 18) is made via flexible conductive material or metallic finger-stock or gaskets (19, 20).

6. Arrangement according to claims 1 and 2, in which the second zone or zones (8') are determined by portions of the printed circuit board which protrude through the enclosure.

7. Arrangement according to claim 1 in which the second zone or zones (8') are determined by intermediate portions of the printed circuit board which are accesible through apertures formed in the enclosure.

8. Arrangement according to claim 1 in which the second zone of the printed circuit board (8') is located within an electrically enveloping enclosure (45).

9. Arrangement according to claim 8 in which the electrically enveloping enclosure for the second zone (8') is the same enclosure (10) as for the zone (8).

## Patentansprüche

1. Anordnung zum Verhindern einer elektromagnetischen Störung in elektronischen Geräten mit einer gedruckten Leiterplatte, wobei in der Anordnung:
(a) die gedruckte Leiterplatte zwei Zonentypen enthält:
- einen ersten Zonentyp (8) mit Quellen hochfrequenter Energie, der sich in einem elektrisch leitenden Hüllgehäuse oder einer elektrisch leitenden Hüllabschirmung (9, 10) befindet, die so beschaffen ist, daß sie eine direkte elektromagnetische Strahlung sperrt oder dämpft, und
- einen zweiten Zonentyp (8'), der mit der ersten Zone über Leiter (12) elektrisch verbunden ist und nicht im selben Gehäuse oder in dem den ersten Zonentyp (8) enthaltenden Teil des Gehäuses enthalten ist und die Verbindung mit anderen Vorrichtungen ermöglicht,
(b) Filtereinrichtungen (13, 14) auf der Leiterplatte angebracht sind, die so beschaffen sind, daß sie unerwünschte Hochfrequenzenergie aus den die beiden Zonen (8, 8') verbindenden Leitern (12) beseitigen oder dämpfen, und
(c) zwischen den Filtereinrichtungen (13, 14) und dem Gehäuse (9, 10) am Rand oder an den Rändern der beiden verschiedenen Zonentypen (8, 8') der gedruckten Leiterplatte eine hochfrequente elektrische Verbindung (19, 20) angeordnet ist.

2. Anordnung nach Anspruch 1, in der sich der zweite Zonentyp (8') außerhalb des Hüllgehäuses (9, 10) befindet.

3. Anordnung nach Anspruch 1, in der die Verbindung zwischen den Filtereinrichtungen (13, 14) und dem Gehäuse (9, 10) über leitende Zonen (17, 18) an der oberen und/oder der unteren Fläche der gedruckten Leiterplatte am Rand der beiden Zonentypen (8, 8') erreicht wird.

4. Anordnung nach Anspruch 3, wobei die leitenden Zonen (17, 18) miteinander über transversale leitende Elemente (21, 22, 22', ...) elektrisch verbunden sind.

5. Anordnung nach den Ansprüchen 1 bis 4, wobei der mechanische und der elektrische Kontakt zwischen dem Gehäuse (9, 10) und den leitenden Zonen (17, 18) über ein flexibles leitendes Material oder über Metallfingermaterial oder über Dichtungen (19, 20) geschaffen wird.

6. Anordnung nach Anspruch 1 oder 2, in der die zweite Zone oder die zweiten Zonen (8') durch Abschnitte der gedruckten Leiterplatte bestimmt sind, die durch das Gehäuse vorstehen.

7. Anordnung nach Anspruch 1, in der die zweite Zone oder die zweiten Zonen (8') durch Zwischenabschnitte der gedruckten Leiterplatte bestimmt sind, die durch im Gehäuse ausgebildete Öffnungen zugänglich sind.

8. Anordnung nach Anspruch 1, in der die zweite Zone der gedruckten Leiterplatte (8') sich in einem elektrisch einhüllenden Gehäuse (45) befindet.

9. Anordnung nach Anspruch 8, in der das elektrisch einhüllende Gehäuse für die zweite Zone (8') das gleiche Gehäuse (10) wie für die erste Zone (8) ist.

## Revendications

1. Dispositif protégeant des interférences électromagnétiques dans des appareils électroniques comportant une plaquette à circuits imprimés, dispositif dans lequel :
(a) la plaquette à circuits imprimés comprend deux types de zones :
- un premier type de zone (8) avec des sources d'énergie haute fréquence et qui est situé à l'intérieur d'un bouclier ou protection enveloppante conductrice électriquement (9, 10) conçu pour empêcher ou atténuer le rayonnement électromagnétique direct, et
- un second type de zone (8') qui est électriquement connecté à la première zone par des conducteurs (12) qui n'est pas logé dans la même protection ou partie de protection contenant le premier type de zone (8) permettant la connexion à d'autres dispositifs,
(b) des moyens de filtration (13, 14) incorporés dans la plaquette à circuits et qui sont conçus pour enlever ou atténuer l'énergie haute fréquence indésirable des conducteurs (12) qui relient les deux zones (8, 8'), et
(c) une connexion électrique haute fréquence (19, 20) entre les moyens de filtration (13, 14) et la protection (9, 10) est disposée à la ou aux limites de deux différents types de zones de la plaquette à circuits imprimés (8, 8').

2. Dispositif selon la revendication 1, dans lequel la zone du second type (8') est située à l'extérieur de la protection enveloppante (9, 10).

3. Dispositif selon la revendication 1, dans lequel la connexion entre les moyens de filtrage (13, 14) et la protection (9, 10) s'effectue par des zones conductrices (17, 18) sur les faces supérieures et/ou inférieures de la plaquette à circuits imprimés à la limite des deux types de zones (8,8').

4. Dispositif selon la revendication 3, dans lequel les zones conductrices (17, 18) sont reliées entre elles électriquement au moyen d'éléments conducteurs transversaux (21, 22, 22' ...).

5. Dispositif selon les revendications 1 à 4, dans lequel le contact mécanique électrique entre la protection (9, 10) et les zones conductrices (17, 18) est réalisé par l'intermédiaire d'un matériau conducteur souple ou de joints ou plots métalliques (19, 20).

6. Dispositif selon les revendications 1 et 2, dans lequel la seconde zone ou les zones (8') sont déterminées par les portions de la plaquette à circuits imprimés qui font saillie à travers la protection.

7. Dispositif selon la revendication 1, dans lequel la seconde zone ou les zones (8') sont déterminées par des portions intermédiaires de la plaquette à circuits imprimés qui sont accessibles par des ouvertures formées dans la protection.

8. Dispositif selon la revendication 1, dans lequel la seconde zone de la plaquette à circuits imprimés (8') est située dans une protection enveloppante électriquement (45).

9. Dispositif selon la revendication 8, dans lequel la protection enveloppante électriquement pour la seconde zone (8') est la même protection (10) que pour la zone (8).
